# EUROPÄISCHE PATENTSCHRIFT

(11) **EP 0 886 993 B1**
(45) Veröffentlichungstag und Bekanntmachung des Hinweises auf die Patenterteilung: **11.08.1999**
(21) Anmeldenummer: 97915327.7
(22) Anmeldetag: 03.03.1997
(51) Int. Cl.: H05K 7/14, G06F 1/18

(54) **BAUGRUPPE EINES ELEKTRISCHEN GERÄTES**
MODULE OF AN ELECTRICAL DEVICE
MODULE D'APPAREIL ELECTRIQUE

(30) Priorität: 13.03.1996 DE 19609855
(43) Veröffentlichungstag der Anmeldung: 30.12.1998
(73) Patentinhaber: Siemens Nixdorf Informationssysteme AG, 33106 Paderborn (DE)
(72) Erfinder: ELLEBRECHT, Friedhelm, D-33034 Brakel (DE); KNOOP, Franz-Josef, D-33142 Büren (DE)
(74) Vertreter: Epping, Wilhelm, Dr.-Ing.
(86) Internationale Anmeldenummer: DE9700388
(87) Internationale Veröffentlichungsnummer: WO9734453

(56) Entgegenhaltungen:
- DE-A- 2 652 933
- DE-A- 4 406 520
- US-A- 4 702 535
- US-A- 4 742 477

## Beschreibung

Die Erfindung betrifft eine Baugruppe eines elektrischen Gerätes mit einer in das Gerät einschiebbaren und an eine Geräterückwand ansteckbaren Geräteleiterplatte; (vgl. US-A-4 742 477).

Elektrische oder elektronische Geräte wie beispielsweise Datenverarbeitungsgeräte umfassen üblicherweise eine Anzahl von Baugruppen, die in Form von Einschüben in ein Gerätechassis eingeschoben und mit einer Geräterückwand über Stecker verbunden werden. Für die einzuschiebenden Leiterplatten gibt es nicht nur mehrere unterschiedliche genormte Formate sondern es hat sich auch eingebürgert, bestimmte Einheiten oder Baugruppen unter Verwendung von Leiterplatten eines bestimmten Formates aufzubauen. Sollen solche Baugruppen mit Leiterplatten unterschiedlicher Formate in einem Gerät verwendet werden, so müssen entsprechende Führungen für derartige unterschiedlich große Baugruppen in den Gerätechassis vorgesehen werden. Dies führt bei Geräten mit unterschiedlicher Geräteausstattung zu erhöhten Produktionskosten wegen unterschiedlich aufgebauter Chassis und erschwert in der Regel auch die Zugänglichkeit der Baugruppen für Wartungsmaßnahmen.

Der Erfindung liegt die Aufgabe zugrunde, eine Baugruppe der eingangs genannten Art so auszubilden, daß Leiterplatten oder Karten unterschiedlichen Formats in einem Standardgerätechassis verwendet werden können und auf einfache Weise montiert und demontiert werden können.

Diese Aufgabe wird erfindungsgemäß dadurch gelöst, daβ mit der Geräteleiterplatte ein quaderförmiger Käfig verbunden ist, in dem senkrecht zu der Geräteleiterplatte und mit dieser über Stecker elektrisch verbunden eine Käfigrückwand angeordnet ist, die ihrerseits Stecker zur elektrischen Verbindung mit in den Käfig einschiebbaren karten- oder platinenförmigen Käfigeinschüben hat, deren Format von dem der Geräteleiterplatte verschieden ist.

Die den Käfig tragende Geräteleiterplatte kann wie jede andere Leiterplatte auch in das Gerätechassis eingeschoben und aus diesem herausgezogen werden. Vorzugsweise hat dabei der Käfig Führungen zum Einschieben der Käfigeinschübe mit parallel zur Geräteleiterplatte gerichteter Einschubrichtung. Das bedeutet, daß die Käfigeinschübe aus dem Käfig nach derselben Seite herausgezogen werden können, nach der auch die Geräteleiterplatte aus dem Gerätechassis herausgezogen werden kann. Damit können die Käfigeinschübe aber aus dem Käfig auch herausgezogen oder in diesen eingeschoben werden, ohne daß die Geräteleiterplatte aus dem Gerätechassis herausgezogen werden muß.

Die Käfigeinschübe können von Platinen gebildet sein, die innerhalb des Käfigs parallel zur Geräteleiterplatte gerichtet sind. Der Käfig kann jedoch auch mindestens ein Einschubfach zur Aufnahme einer Unterbaugruppe haben, die eine senkrecht zur Geräteleiterplatte und zur Käfigrückwand gerichtete und an diese ansteckbare Baugruppenrückwand sowie an diese ansteckbare Baugruppenplatinen hat, die parallel zur Geräteleiterplatte und senkrecht zur Käfigrückwand gerichtet sind. Die Unterbaugruppe wird als Ganzes parallel zur Einschubrichtung der Geräteleiterplatte in den Käfig eingeschoben oder aus diesem herausgezogen, während die Steckrichtung der Baugruppenplatinen für eine Verbindung mit der Baugruppenrückwand im eingebauten Zustand der Baugruppen senkrecht zur Einschubrichtung der Geräteleiterplatte ist.

Vorzugsweise hat die Unterbaugruppe ein kastenförmiges offenes Gehäuse mit einem rechteckigen Boden, zwei zueinander parallelen Seitenwänden und einem quer zu diesen gerichteten stirnseitigen Rahmen, wobei die Baugruppenrückwand in dem Gehäuse parallel zum Boden angeordnet ist und auf ihrer Oberseite Stecker zur Verbindung mit den Baugruppenplatinen hat, die an einem Längsrand einen Gegenstecker zur Verbindung mit der Baugruppenrückwand und an einem dazu senkrechten Rand eine Frontblende haben derart, daß die Frontblenden der auf die Baugruppenrückwand aufgesteckten Baugruppenplatinen den Stirnrahmen verschließen. Damit kann die Baugruppe als Ganzes in den Käfig eingeschoben werden, wobei die von den Frontblenden gebildete metallische geschlossene Wand die von dem Käfig gelieferte Abschirmung vervollständigt. Die vorstehend beschriebene Lösung ermöglicht es, Karten nach dem PC-AT-Standard, deren Einschubrichtung an sich senkrecht zu der Einschubrichtung der Geräteleiterplatte in das Gerätechassis 10 ist, ebenfalls in Form einer einschiebbaren Unterbaugruppe in den Käfig und damit in das Gerätechassis einzuschieben.

Weitere Merkmale und Vorteile der Erfindung ergeben sich aus der folgenden Beschreibung, welche in Verbindung mit den beigefügten Zeichnungen die Erfindung anhand eines Ausführungsbeispieles erläutert. Es zeigen:
- Figur 1: eine schematische perspektivische Frontansicht eines Gerätechassis mit einer erfindungsgemäßen Baugruppe,
- Figur 2: eine perspektivische Ansicht der Baugruppe ohne Einschübe,
- Figur 3: eine schematische perspektivische Darstellung der in der Baugruppe elektrisch miteinander verbundenen Platinen gemäß einer ersten Ausführungsform der Erfindung,
- Figur 4: eine der Figur 3 entsprechende Darstellung der Platinen der Baugruppe gemäß einer zweiten Ausführungsform der Erfindung und
- Figur 5: eine perspektivische Darstellung einer Unterbaugruppe.

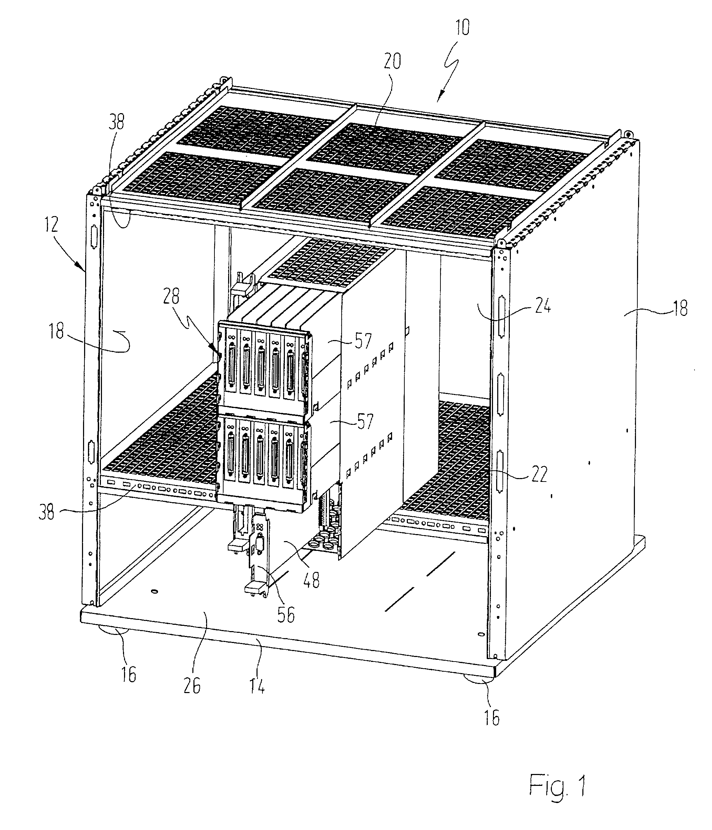

Ein in Figur 1 allgemein mit 10 bezeichnetes Gerätechassis umfaßt einen quaderförmigen offenen Rahmen 12, der aus miteinander verschraubten oder verschweißten Metalprofilen besteht. Der Rahmen 12 ist auf einer Bodenplatte 14 befestigt, die ihrerseits auf Füßen oder Rollen 16 aufliegt. Die Seitenflächen des Rahmens 12 sind durch Wände 18 geschlossen. Die Oberseite des Rahmens wird von einer ersten Führungsplatte 20 gebildet. Der von dem Rahmen 12 umschlossene Innenraum wird durch eine zur oberen Führungsplatte 20 parallele untere Führungsplatte 22 in einen zur Aufnahme von Einschüben bestimmten oberen Raum 24 und einen unteren Raum 26 unterteilt, der zur Aufnahme mindestens eines Netzteiles oder anderer Versorgungseinheiten bestimmt ist. Die in den Raum 24 einzuschiebenden Einschübe sind üblicherweise Leiterplatten, deren Höhe und Breite der Höhe und Tiefe des Raumes 24 entspricht. Die Führungen zum Einschieben dieser Leiterplatten sind nicht dargestellt. Die Figur 1 zeigt ferner einen speziellen Einschub oder eine erfindungsgemäße Baugruppe 28, die im folgenden näher erläutert werden soll.

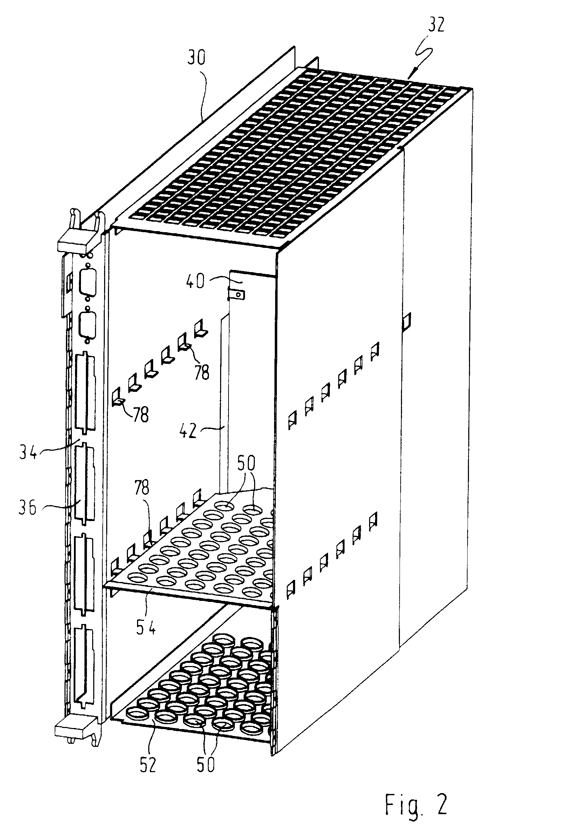

Figur 2 zeigt von der in Figur 1 dargestellten Baugruppe 28 eine zum Einschieben in den Raum 24 des Gerätechassis 10 bestimmte Leiterplatte 30, an der ein quaderförmiger Metallkäfig 32 befestigt ist. An ihrer in Einschubrichtung nacheilenden Kante trägt die Leiterplatte 30 ferner eine Blende 34, die Durchbrechungen zur Aufnahme von Steckern 36 hat und an ihrem oberen und unteren Längsende jeweils an einer Anschraubleiste 38 des Chassis 10 anschraubbar ist. Der Käfig 32 dient zur Aufnahme weiterer Leiterplatten oder Käfigeinschübe, deren Format jedoch von dem der Leiterplatten 30 verschieden ist, so daß sie nicht in den Aufnahmeraum 24 des Chassis 10 eingeschoben werden könnten.

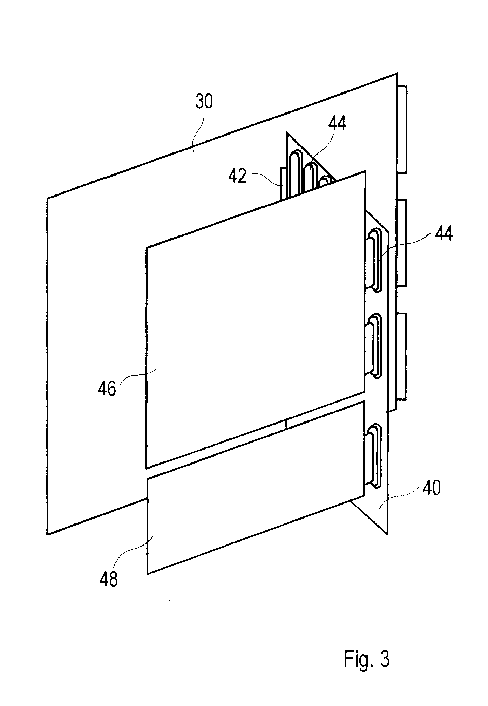

Innerhalb des Käfigs 32 befindet sich eine Käfigrückwand 40, die über einen Stecker 42 mit der Leiterplatte 30 elektrisch verbunden ist und ihrerseits Stecker 44 trägt, welche eine Steckverbindung mit Käfigeinschüben oder Leiterplatten 46, 48 unterschiedlichen Formats erlauben, wie dies in Figur 3 dargestellt ist. Figur 1 zeigt dabei drei Gruppen von Leiterplatten, die mit Hilfe von Führungen 50, die an einem Käfigboden 52 bzw. in den Käfigboden eingeschobenen Zwischenböden 54 ausgebildet sind, in den Käfig 32 eingeschoben und an die Käfigrückwand 40 angesteckt werden können. In Figur 3 sind stattdessen nur zwei Gruppen von Platinen dargestellt. Wie Figur 1 zeigt, können die Käfigeinschübe 48 an ihren in Einschubrichtung nacheilenden Ränder jeweils Blenden 56 tragen, die nach dem Einschieben der Platinen 46, 48 in einer Ebene mit der Blende 34 der Leiterplatte 30 liegen, so daß sie zusammen mit dieser eine geschlossene Wand bilden, die als Abschirmung gegen elektromagnetische Störstrahlung dient.

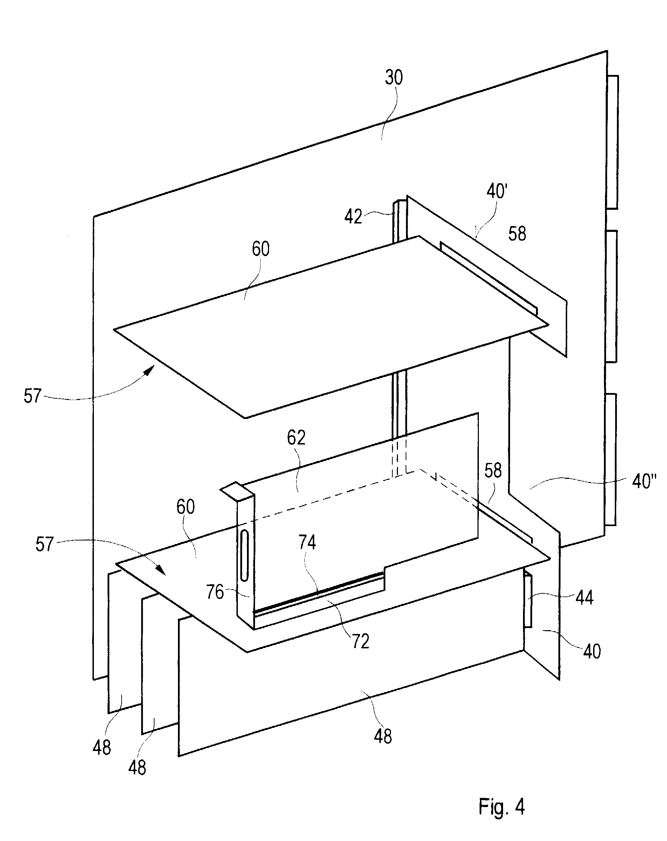

Die spezielle Art des Aufbaus der Baugruppen kann es erfordern, daß die Platinen innerhalb des Käfigs anders gesteckt werden müssen. Die Figuren 1 und 4 zeigen eine Ausführungsvariante, bei welcher an die Käfigrückwand 40 zwei Unterbaugruppen 57 angesteckt sind, deren jede eine an die Käfigrückwand 40 mittels eines Steckers 58 angesteckte Baugruppenrückwand 60 umfaßt, die senkrecht sowohl zur Leiterplatte 30 als auch zur Käfigrückwand 40 gerichtet ist und ihrerseits eine Mehrzahl von Karten 62 trägt, die wiederum parallel zur Leiterplatte 30 gerichtet sind.

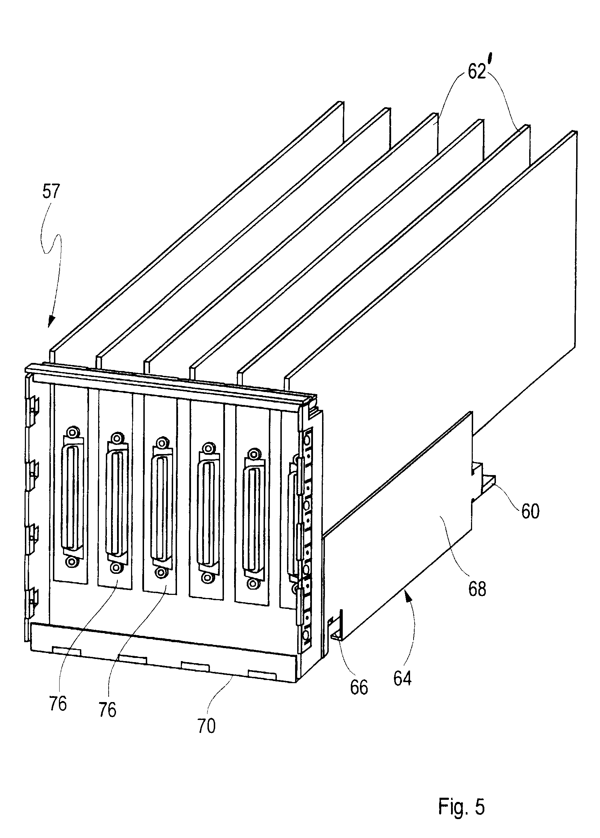

Die Unterbaugruppen 57 umfassen dabei gemäß Figur 5 ein allgemein mit 64 bezeichnetes kastenförmiges offenes Gehäuse mit einem rechteckigen Boden 66, zwei zueinander parallelen Seitenwänden 68 (von denen in der Figur 5 nur eine zu sehen ist) und einen quer zu diesen gerichteten stirnseitigen Rahmen 70. Die Baugruppenrückwand 60 ist in dem kastenförmigen Gehäuse 64 parallel zum Boden 66 angeordnet und trägt auf ihrer Oberseite Stecker 72 (Figur 4) zur Verbindung mit den Baugruppenplatinen 62, die beispielsweise Karten nach dem PC-AT-Standard sind. Diese haben an einem ihrer Längsränder jeweils einen Gegenstekker 74 zum Einstecken in den Stecker 72 an der Baugruppenrückwand 60 und an einem dazu senkrechten Rand eine Frontblende 76 derart, daß die Frontblenden 76 der auf die Baugruppenrückwand 60 aufgesteckten Baugruppenplatinen 62 den Stirnrahmen 70 verschließen, wie dies Figur 5 zeigt. Die Baugruppengehäuse können in den Käfig 32 auf Führungen eingeschoben werden, die von einwärts gebogenen Laschen 78 in den Käfigseitenwänden (Figur 2) gebildet sind. Wie Figur 5 zeigt, ist die Tiefe des kastenförmigen Gehäuses 64 an PC-AT-Baugruppenplatinen 62' im Kurzformat angepaßt. Um auch Baugruppenplatinen 62 im PC-AT-Langformat einsetzen zu können, ist an den dafür vorgesehenen Steckplätzen die Käfigrückwand 40 niedrig gehalten, wie dies in Figur 4 bei 40' gezeigt ist, oder mit einem Ausschnitt 40" versehen.

Wie die vorstehende Beschreibung zeigt, können Unterbaugruppen mit Karten in einem Format, das von dem Format der in das Gerätechassis eingeschobenen Leiterplatten völlig verschieden ist, in dem Käfig 32 untergebracht werden, ohne daß das Chassis insgesamt verändert werden muß. Der Käfig 32 selbst kann wie ein Einschub in dem Chassis 10 behandelt werden. Diese Lösung ermöglicht den Aufbau von Geräten unterschiedlicher Ausstattung mit demselben Chassis, wobei dennoch die Montage und Demontage der einzelnen Baugruppen und Unterbaugruppen äußerst einfach ist, was nicht nur die Produktionskosten, sondern auch den zeitlichen Aufwand für Wartungsarbeiten senkt.

## Patentansprüche

1. Baugruppe eines elektrischen Gerätes mit einer in das Gerät einschiebbaren und an einer Geräterückwand ansteckbaren Geräteleiterplatte (30), dadurch **gekennzeichnet,** daß an der Geräteleiterplatte (30) ein quaderförmiger Käfig (32) befestigt ist, in dem senkrecht zu der Geräteleiterplatte (30) und mit dieser über Stecker (42) verbunden, eine Käfigrückwand (40) angeordnet ist, die ihrerseits Stecker (44) zur elektrischen Verbindung mit in den Käfig (32) einschiebbaren karten- oder platinenförmigen Käfigeinschüben (46, 48) hat, deren Format von dem der Geräteleiterplatte (30) verschieden ist.

2. Baugruppe nach Anspruch 1, dadurch **gekennzeichnet,** daß der Käfig Führungen (50) zum Einschieben der Käfigeinschübe mit parallel zur Geräteleiterplatte (30) gerichteter Einschubrichtung hat.

3. Baugruppe nach Anspruch 1 oder 2, dadurch **gekennzeichnet,** daß der Käfig (32) mindestens ein Einschubfach zur Aufnahme einer Unterbaugruppe mit einer senkrecht zur Geräteleiterplatte (30) und zur Käfigrückwand (40) gerichteten und an diese ansteckbaren Baugruppenrückwand (60) und mit an diese ansteckbaren Baugruppenplatinen hat, die parallel zur Geräteleiterplatte (30) und senkrecht zur Käfigrückwand (40) gerichtet sind.

4. Baugruppe nach Anspruch 3, dadurch **gekennzeichnet,** daß die Unterbaugruppe (57) ein kastenförmiges offenes Gehäuse (64) mit einem rechteckigen Boden (66), zwei zueinander parallelen Seitenwänden (68) und einem quer zu diesen gerichteten stirnseitigen Rahmen (70) hat, wobei die Baugruppenrückwand (60) in dem Gehäuse (64) parallel zum Boden (66) angeordnet ist und auf ihrer Oberseite Stecker (72) zur Verbindung mit den Baugruppenplatinen (62) hat, die jeweils an einem Längsrand einen Gegenstecker (74) zur Verbindung mit der Baugruppenrückwand (60) und an einem dazu senkrechten Rand eine Frontblende (76) haben derart, daß die Frontblenden (76) der auf die Baugruppenrückwand (60) aufgesteckten Baugruppenplatinen (72) den Stirnrahmen (70) verschließen.

## Claims

1. Module of an electrical device with a device printed circuit board (30) which can be pushed into the device and plugged onto a backplane of the device, characterized in that a cuboid cage (32) is fastened to the device printed circuit board (30), which cage has a backplane (40) arranged perpendicular to the device printed circuit board (30) and connected to the latter by means of connectors (42), the backplane of the cage having its own connectors (44) for electrical connection to cage push-in units (46,48), in the form of cards or boards, which can be inserted into the cage (32) and whose format is different than that of the printed circuit board (30).

2. Module according to Claim 1, characterized in that the cage has guides (50) for inserting the push-in units in a direction parallel to the printed circuit board (30).

3. Module according to Claim 1 or 2, characterized in that the cage (32) has at least one push-in unit compartment for holding a subsidiary module having a module backplane (60), which is positioned perpendicular to the device printed circuit board (30) and to the backplane (40) of the cage and can be plugged onto this backplane, and having module boards which can be plugged onto the module backplane (60) and are positioned parallel to the printed circuit board (30) and perpendicular to the backplane (40) of the cage.

4. Module according to Claim 3, characterized in that the subsidiary module (57) has a box-shaped open casing (64) with a rectangular base (66), two mutually parallel side walls (68) and an end frame (70) positioned transversely with respect to the side walls, the module backplane (60) being arranged in the casing (64) parallel to the base (66) and having connectors (72) at the top for connection to the module boards (62), which each have, on one longitudinal edge, a mating connector (74) for connection to the module backplane (60) and, on one edge perpendicular to the latter, a front panel (76), so that the front panels (76) of the module boards (72) plugged onto the module backplane (60) close off the end frame (70).

## Revendications

1. Module d'un appareil électrique comportant une plaquette (30) à circuit imprimé d'appareil pouvant être enfilée dans l'appareil et embrochée sur un panneau arrière d'appareil, caractérisé en ce qu'il est fixé à la plaquette (30) à circuit imprimé d'appareil une cage (32) parallélépipédique dans laquelle est monté, perpendiculairement à la plaquette (30) un circuit imprimé d'appareil et en étant relié à celle-ci par l'intermédiaire de connecteurs (42), un panneau (40) arrière de cage qui a pour sa part des connecteurs (44) pour la liaison conductrice de l'électricité avec des inserts (46, 48) de cage en forme de carte ou de platine, qui peuvent être enfilés dans la cage (32) et dont le format est différent de celui de la plaquette (30) à circuit imprimé d'appareil.

2. Module suivant la revendication 1, caractérisé en ce que la cage a des glissières (50) pour enfiler les inserts de cage en ayant une direction d'enfilage dirigée parallèlement à la plaquette (30) à circuit imprimé d'appareil.

3. Module suivant la revendication 1 ou 2, caractérisé en ce que la cage (32) a au moins un casier d'insert pour la réception d'un sous-module ayant un panneau (60) arrière de modules dirigé perpendiculairement à la plaquette (30) à circuit imprimé d'appareil et au panneau (40) arrière de cage et pouvant être embrochée sur celui-ci, et comportant des platines de modules qui peuvent être embrochées sur le panneau arrière de modules et qui sont dirigées parallèlement à la plaquette (30) à circuit imprimé d'appareil et perpendiculairement au panneau (40) arrière de cage.

4. Module suivant la revendication 3, caractérisé en ce que le sous-module (57) a un boîtier (64) ouvert, en forme de caisse, comportant un fond (66) rectangulaire, deux parois (68) latérales parallèles l'une à l'autre et un cadre (70) frontal, dirigé perpendiculairement à celles-ci, le panneau (60) arrière de module étant monté dans le boîtier (64) parallèlement au fond (66) et ayant sur sa face supérieure des connecteurs (72) pour la liaison aux platines (62) de modules qui ont chacune sur un bord longitudinal un connecteur (74) antagoniste pour la liaison aux panneaux (60) arrières de modules et, sur un bord perpendiculaire à cela, un panneau (76) frontal, de telle sorte que les panneaux (76) frontaux des platines (72) de modules embrochées sur le panneau (60) arrière de modules ferment le cadre (70) frontal.
